(19) Europäisches Patentamt
European Patent Office
Office européen des brevets

(11) **EP 4 401 101 A2**

(12) **EUROPEAN PATENT APPLICATION**

(43) Date of publication:
**17.07.2024 Bulletin 2024/29**

(21) Application number: **24150391.1**

(22) Date of filing: **04.01.2024**

(51) International Patent Classification (IPC):
*H01G 4/008* (2006.01)  *H01G 4/012* (2006.01)
*H01G 4/12* (2006.01)  *H01G 4/33* (2006.01)
*H01G 4/08* (2006.01)  *H10B 12/00* (2023.01)

(52) Cooperative Patent Classification (CPC):
**H01G 4/33; H01G 4/008; H01G 4/012;
H01G 4/1209; H01G 4/1272; H01L 28/56;**
H01G 4/085; H01L 28/75; H10B 12/30

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **11.01.2023 KR 20230004289**

(71) Applicant: **Samsung Electronics Co., Ltd.
Suwon-si, Gyeonggi-do 16677 (KR)**

(72) Inventors:
• **KIM, Haeryong
Suwon-si 16678 (KR)**

• **LEE, Jinho
Hwaseong-si 18448 (KR)**
• **KIM, Donghyun
Suwon-si 16678 (KR)**
• **KIM, Beomseok
Hwaseong-si 18448 (KR)**
• **KIM, Cheheung
Suwon-si 16678 (KR)**
• **LEE, Jooho
Suwon-si 16678 (KR)**

(74) Representative: **Elkington and Fife LLP
Prospect House
8 Pembroke Road
Sevenoaks, Kent TN13 1XR (GB)**

(54) **CAPACITOR AND DEVICE INCLUDING THE SAME**

(57) Provided are a capacitor and an electronic device including the same. The capacitor includes a first electrode layer, a second electrode layer, a dielectric layer disposed between the first electrode layer and the second electrode layer, and an interlayer disposed between the first electrode layer and the dielectric layer. The interlayer includes a first interface material, the first interface material includes at least one Group 13 element, and the at least one Group 13 element is not aluminum (Al).

FIG. 1

100

| 190 |
|---|
| 150 |
| 130 |
| 110 |

**Description**

FIELD OF THE INVENTION

The disclosure relates to a capacitor and a device including the same.

BACKGROUND OF THE INVENTION

Semiconductor elements, such as memories and transistors, are used in a wide variety of household and industrial apparatuses. Along with higher performance of household and industrial apparatuses, semiconductor elements become more highly integrated and finer.

As the semiconductor elements become more highly integrated and finer, the semiconductor elements are smaller in size. For example, a decrease in the size of a capacitor leads to a decrease in the capacity of the capacitor and an increase in leakage current, and thus various methods are suggested in order to solve these tasks.

For example, the capacity of a capacitor is maintained by changing a capacitor structure, for example, by enlarging an electrode area or reducing the thickness of a dielectric layer.

SUMMARY OF THE INVENTION

Provided is a capacitor having higher capacitance and reduced leakage current and a device including the same.

Additional aspects will be set forth in part in the description which follows and, in part, will be apparent from the description, or may be learned by practice of the presented embodiments of the disclosure.

According to an aspect, provided is a capacitor including a first electrode layer, a second electrode layer, a dielectric layer between the first electrode layer and the second electrode layer, and an interlayer between the first electrode layer and the dielectric layer, wherein the interlayer includes a first interface material, and the first interface material includes at least one Group 13 element other than aluminum (Al).

According to another aspect, provided is a device including the capacitor.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a cross-sectional view illustrating a schematic structure of a capacitor according to at least one embodiment;
FIG. 2 is a graph showing a capacitance versus a voltage in a capacitor according to at least one embodiment;
FIG. 3 is a graph showing a leakage current versus an equivalent oxide thickness ($T_{oxeq}$) in a capacitor according to at least one embodiment;
FIG. 4 is a graph showing a capacitance versus a voltage in a capacitor according to at least one embodiment;
FIG. 5 is a graph showing a leakage current versus an equivalent oxide thickness ($T_{oxeq}$) in a capacitor according to at least one embodiment;
FIG. 6 is a circuit diagram illustrating a schematic circuit configuration and operation of an electronic device that uses a capacitor according to embodiments;
FIG. 7 is a schematic diagram illustrating an electronic device according to at least one embodiment;
FIG. 8 is a schematic diagram illustrating an electronic device according to another embodiment;
FIG. 9 is a plan view illustrating an electronic device according to another embodiment;
FIG. 10 is a cross-sectional view taken along line A-A' in FIG. 9;
FIG. 11 is a cross-sectional view illustrating an electronic device according to another embodiment; and
FIGS. 12 and 13 are each a conceptual view schematically illustrating an element architecture applicable to a device according to at least one embodiment.

DETAILED DESCRIPTION

Reference will now be made in detail to some embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The present inventive concept to be described later may have various modifications and may be embodied in different forms, and particular embodiments will be explained in detail with reference to the accompanying drawings. It should be understood, however, that it is not intended to limit the inventive concept to the particular forms disclosed, but rather, is intended to include all modifications, equivalents, and alternatives falling within the scope of the present inventive concept.

The terminology used hereinafter is for the purpose of merely describing particular embodiments and is not intended to be limiting of the present inventive concept. The singular terms include the plural terms as well unless the context clearly indicates otherwise. When the terms "about" or "substantially" are used in this specification in connection with a numerical value and/or geometric terms, it is intended that the associated numerical value includes a manufacturing tolerance (e.g., ±10%) around the stated numerical value. Further, regardless of whether numerical values and/or geometric terms are modified as "about" or "substantially," it will be understood that these values should be construed as including a manufacturing or operational tolerance (e.g., ±10%) around the stated numerical values and/or geometric. When referring to "C to D", this means C inclusive to D inclusive unless otherwise specified. Hereinafter, it will be understood that the term "includes" or "comprises", when used in this specification, specifies the presence of stated features, integers, steps, operations, elements, parts, components, materials, or a combination thereof, but does not preclude the presence or addition of one or more other features, integers, steps, operations, elements, parts, components, materials, or combinations thereof. As used hereinafter, "/" may be construed as "and" or "or" depending on the situation.

In the drawings, the thickness is enlarged or reduced to clearly express the different layers and regions. Like drawing reference numerals are used for like elements through the specification. Throughout the specification, when a layer, a film, a region, a plate, etc., is referred to as being "on" or "above" another element, it can be directly on the other element or intervening elements may be present, unless expressly indicated otherwise.

It will also be understood that spatially relative terms, such as "above", "top", etc., are intended to encompass different orientations of the device in use or operation in addition to the orientation depicted in the figures, and that the device may be otherwise oriented (rotated 90 degrees or at other orientations) and the spatially relative terms used herein interpreted accordingly. The terms of first, second, and the like may be used herein to describe various elements, and the elements should not be limited by terms. The terms are only used to distinguish one element from another element. Like drawing reference numerals are used for components having substantially the same functional configuration, and duplicate descriptions thereof will be omitted.

Also, functional terms such as those including "unit", "...er/or", and "module" described in the specification mean units that process at least one function or operation, and may be implemented as processing circuitry such as hardware, software, or a combination of hardware and software. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc., and/or electronic circuits including said components.

Hereinafter, a capacitor and a device including the same according to embodiments will be described in more detail.

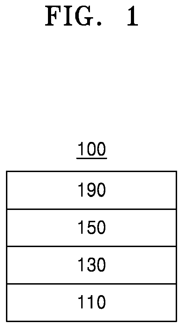

FIG. 1 is a cross-sectional view illustrating a schematic structure of a capacitor according to at least one embodiment.

A capacitor 100 according to at least one embodiment includes: a first electrode layer 110; a second electrode layer 190; a dielectric layer 150 disposed between the first electrode layer 110 and the second electrode layer 190; and an interlayer 130 disposed between the first electrode layer and the dielectric layer 150, wherein the interlayer includes a first interface material, the first interface material includes at least one Group 13 element, and the at least one Group 13 element is not aluminum (Al).

Since the capacitor according to at least one embodiment includes the above interlayer, a structural deterioration of the dielectric layer due to an oxidation of an electrode may be prevented, and the capacitor may have comparatively excellent structural stability and dielectric characteristics, and have higher capacitance and lower leakage current characteristics.

The capacitor according to at least one embodiment includes a Group 13 element other than aluminum in the interlayer disposed between the first electrode layer and the dielectric layer. When aluminum is included in an interface between the first electrode layer and the dielectric layer, structural or crystalline deterioration may occur due to diffusion of aluminum, thereby reducing the capacitance of the capacitor. In contrast, since the capacitor according to at least one embodiment includes a Group 13 element other than aluminum, the capacitor may have higher capacitance characteristics while reducing leakage current.

According to at least one embodiment, the Group 13 element included in the first interface material may be at least one of boron (B), gallium (Ga), indium (In), and/or thallium (Tl).

According to at least one embodiment, the first interface material may include an oxide of the Group 13 element.

According to at least one embodiment, the first interface material may include gallium oxide, indium oxide, and/or a combination thereof.

According to at least one embodiment, the first interface material may have a work function of 3.5 eV or higher.

For example, the first interface material may have a work function of about 3.5 eV to about 10 eV, about 3.7 eV to about 9 eV, and/or about 4 eV to about 8 eV.

According to at least one embodiment, the interlayer may have a single layer structure, or a composite layer structure of two or more layers.

According to at least one embodiment, the interlayer may consist of a first layer including the first interface material.

According to at least one embodiment, the interlayer may include the first layer and a second layer, the first layer may include the first interface material, the second layer may include a second interface material, and the second interface material may include at least one Group 13 element.

According to at least one embodiment, the Group 13 element included in the second interface material may be a Group 13 element other than aluminum.

According to at least one embodiment, the description of the second interface material may be the same (or substantially similar) to the description of the first interface material.

According to at least one embodiment, the first interface material and the second interface material may be different from each other. For example, the first interface material may include a first Group 13 element other than aluminum, and the second interface material may include a second Group 13 element other than aluminum, and the first Group 13 element and the second Group 13 may be different elements.

According to at least one embodiment, the interlayer may be in direct contact with the first electrode layer.

According to at least one embodiment, the interlayer may be in direct contact with the dielectric layer.

According to at least one embodiment, the interlayer may be and/or include an amorphous structure.

According to at least one embodiment, the interlayer may have a thickness of 15 Å or less. For example, the thickness of the interlayer may be about 0.1 Å to about 15 Å, about 0.5 Å to about 12 Å, and/or about 1 Å to about 10 Å.

When the interlayer has a thickness satisfying the aforementioned range, structural deterioration of the dielectric layer may be prevented, and thus the capacitor according to at least one embodiment may have comparatively excellent structural stability and dielectric characteristics and higher capacitance and lower leakage current characteristics.

According to at least one embodiment, the first electrode layer may include a first electrode material. For example, according to at least one embodiment, the first electrode material may be a metal, a metal oxide, a metal nitride, a combination thereof, and/or the like. In at least one embodiment, the first electrode may include at least one of titanium (Ti), nickel (Ni), aluminum (Al), tantalum (Ta), tungsten (W), platinum (Pt), palladium (Pd), gold (Au), iridium (Ir), rhodium (Rh), molybdenum (Mo), vanadium (V) or niobium (Nb), and/or the like as a base element.

For example, the first electrode material may include at least one of a metal (e.g., titanium (Ti), nickel (Ni), aluminum (Al), tantalum (Ta), tungsten (W), platinum (Pt), palladium (Pd), gold (Au), iridium (Ir), rhodium (Rh), molybdenum (Mo), vanadium (V) or niobium (Nb), and/or the like); a oxide (e.g., Ti oxide, Ni oxide, Al oxide, Ta oxide, W oxide, Pt oxide, Pd oxide, Au oxide, Ir oxide, Rh oxide, Mo oxide, V oxide, Nb oxide, and/or the like); a nitride (e.g., Ti nitride, Ni nitride, Al nitride, Ta nitride, W nitride, Pt nitride, Pd nitride, Au nitride, Ir nitride, Rh nitride, Mo nitride, V nitride, Nb nitride, and/or the like); and/or a combination thereof.

According to at least one embodiment, the first electrode layer may include TiN.

According to at least one embodiment, the interlayer may further include the first electrode material included in the first electrode layer, and/or an oxide of the electrode material included in the first electrode layer.

According to at least one embodiment, the interlayer may include a compound represented by Formula 1:

Formula 1 $\quad\quad\quad A_xM_yO_z$

wherein, in Formula 1, A is the Group 13 element other than aluminum, M is the same as a metal included in the first electrode material, x is a real number greater than 0, and less than or equal to 5, y is a real number greater than or equal to 0 and less than or equal to 5, and z is a real number greater than 0, and less than or equal to 5. For example, x, y, and z may also be represented as $0 < x \leq 5$; $0 \leq y \leq 5$; and $0 < z \leq 5$, respectively.

According to at least one embodiment, in Formula 1, A may be at least one of boron (B), gallium (Ga), indium (In), thallium (Tl), and/or a combination thereof.

According to at least one embodiment, in Formula 1, M may be at least one of titanium (Ti), nickel (Ni), aluminum (Al), tantalum (Ta), tungsten (W), platinum (Pt), palladium (Pd), gold (Au), iridium (Ir), rhodium (Rh), molybdenum (Mo), vanadium (V), niobium (Nb), and/or a combination thereof.

For example, the compound represented by Formula 1 may be $Ga_xTi_yO_z$ or $In_xTi_yO_z$.

According to at least one embodiment, the first interface material may include a compound represented by Formula 1 in the interlayer.

According to at least one embodiment, "A" may be contained in an amount of about 1 at% to about 70 at% in the interlayer. For example, "A" may be contained in an amount of about 3 at% to about 60 at%, or about 5 at% to about 50 at% in the interlayer.

According to at least one embodiment, an amount range of the Group 13 element in the interlayer may be defined with respect to elements other than oxygen. For example, according to at least one embodiment, the amount of the Group 13 element may be included in an amount of about 1 at% to about 70 at%, about 3 at% to about 60 at%, or about 5 at% to about 50 at% with respect to elements other than oxygen in the interlayer.

For example, when the interlayer includes $Ga_xTi_yO_z$, the percentage value of Ga (e.g., (number of atoms in Ga)/(number of atoms in Ga + number of atoms in Ti)) in the interlayer may be about 1% to about 70%, about 3% to about 60%, and/or about 5% to about 50%; and/or, when the interlayer includes $In_xTi_yO_z$, the percentage value of In ((number of atoms in In)/(number of atoms in In + number of atoms in Ti)) in the interlayer may be about 1% to about 70%, about 3% to about 60%, and/or about 5% to about 50%.

Since an amount of the Group 13 element in the interlayer falls within the aforementioned range, leakage current characteristics of the first electrode layer is improved, and also deterioration of the first electrode layer is prevented, thereby improving structural stability.

According to at least one embodiment, the interlayer may include a first mixed region.

According to at least one embodiment, the first mixed region may be in direct contact with the first electrode layer.

According to at least one embodiment, the first mixed region may include a mixture of the first interfacial layer material and at least one of the first electrode material and/or an oxide of the first electrode material. The mixture may be (and/or include), for example, a solid solution, a layered structure, an amorphous mixture, and/or the like.

According to at least one embodiment, the dielectric layer may include a dielectric material.

According to at least one embodiment, the dielectric material may include: at least one of zirconium (Zr), hafnium (Hf), titanium (Ti) or aluminum (Al) as a base element. For example, the dielectric material may include an oxide of Zr, an oxide of Hf, an oxide of Ti or an oxide of Al; and/or a combination thereof.

According to at least one embodiment, the dielectric material may include $ZrO_2$, $HfO_2$, $TiO_2$, $Al_2O_3$, and/or a combination thereof.

According to at least one embodiment, the dielectric layer may have a thickness of about 1 nm to about 15 nm. For example, the dielectric layer may have a thickness of about 2 nm to about 12 nm, about 3 nm to about 10 nm, and/or about 4 nm to about 9 nm.

According to at least one embodiment, the interlayer may include a second mixed region.

According to at least one embodiment, the second mixed region may be in direct contact with the dielectric material.

According to at least one embodiment, the second mixed region may include the first interfacial layer material and at least one of the dielectric material and/or an oxide of the dielectric material.

According to at least one embodiment, the second electrode layer may include a second electrode material.

According to at least one embodiment, the second electrode material may be a metal, a metal oxide, a metal nitride, and/or a combination thereof. The second electrode material may be, for example, the same and/or substantially similar to the first electrode material.

According to at least one embodiment, the second electrode material may include at least one of titanium (Ti), nickel (Ni), aluminum (Al), tantalum (Ta), tungsten (W), platinum (Pt), palladium (Pd), gold (Au), iridium (Ir), rhodium (Rh), molybdenum (Mo), vanadium (V), niobium (Nb), and/or the like; Ti oxide, Ni oxide, Al oxide, Ta oxide, W oxide, Pt oxide, Pd oxide, Au oxide, Ir oxide, Rh oxide, Mo oxide, V oxide, Nb oxide, and/or the like; Ti nitride, Ni nitride, Al nitride, Ta nitride, W nitride, Pt nitride, Pd nitride, Au nitride, Ir nitride, Rh nitride, Mo nitride, V nitride, Nb nitride, and/or the like; a combination thereof; etc.

According to at least one embodiment, the first electrode layer and the second electrode layer may each independently have a thickness of about 1 nm to about 30 nm. For example, the first electrode layer and the second electrode layer may each independently have a thickness of about 2 nm to about 20 nm, about 3 nm to about 15 nm, or about 5 nm to about 10 nm.

According to at least one embodiment, provided is an electronic device including a transistor and one of the aforementioned capacitors electrically connected to the transistor.

The transistor may include: a semiconductor substrate including a source region, a drain region, and a channel region disposed between the source region and the drain region; and a gate stack disposed on the semiconductor substrate to face the channel region and including a gate insulating layer and a gate electrode.

The transistor may include: a semiconductor substrate including a source region, a drain region, and a channel region disposed between the source region and the drain region; and a gate stack disposed in a gate line trench to face the channel region and including a gate insulating layer and a gate electrode, the trench being recessed from a surface of the semiconductor substrate.

The electronic device may include a memory unit including the capacitor and the transistor, and a control unit electrically connected to the memory unit and controlling the memory unit.

The aforementioned capacitor may be used in various electronic devices. The aforementioned capacitor may be utilized as a DRAM element together with a transistor. In addition, the aforementioned capacitor may form a portion of an electronic circuit that forms an electronic device, together with other circuit elements.

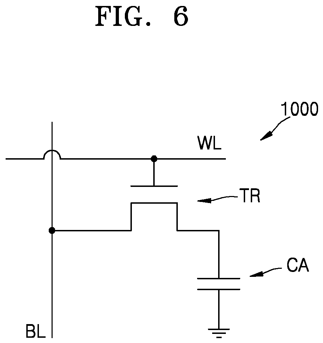

FIG. 6 is a circuit diagram illustrating a schematical circuit configuration and operation of an electronic device including a capacitor according to some embodiments.

A circuit diagram of an electronic device 1000 illustrates one cell of a dynamic random access memory (DRAM) element, and includes a transistor TR, a capacitor CA, a word line WL, and a bit line BL. The electronic device 1000 may be provided as an element in an array of similar DRAM elements. The capacitor CA may be the capacitor 100 described with reference to FIG. 1.

A gate voltage for turning the transistor TR to be in an 'ON' state is applied to the gate electrode through the word line WL, and then VDD (high) or 0 (low), which is a data voltage value to be input, is applied to the bit line BL. When a high voltage is applied to the word line and the bit line, the capacitor CA is charged and thus data "1" is written; and when a high voltage is applied to the word line and a low voltage is applied to the bit line, the capacitor CA is discharged and thus data "0" is written.

When reading data, a high voltage is applied to the word line WL to turn on the transistor TR of the DRAM, and then a voltage of VDD/2 is applied to the bit line BL. When the written data in the DRAM is "1", that is, a voltage of the capacitor CA is VDD, the voltage of the bit line BL becomes slightly higher than VDD/2 while charges in the capacitor CA slowly move to the bit line BL. On contrast, when the written data in DRAM "0" state, charges in the bit line BL move to the capacitor CA, and thus a voltage of the bit line BL becomes slightly lower than VDD/2. An electric potential difference thus generated in the bit line may be detected by a sense amplifier, and the value may be amplified to determine whether the corresponding data is "0" or "1".

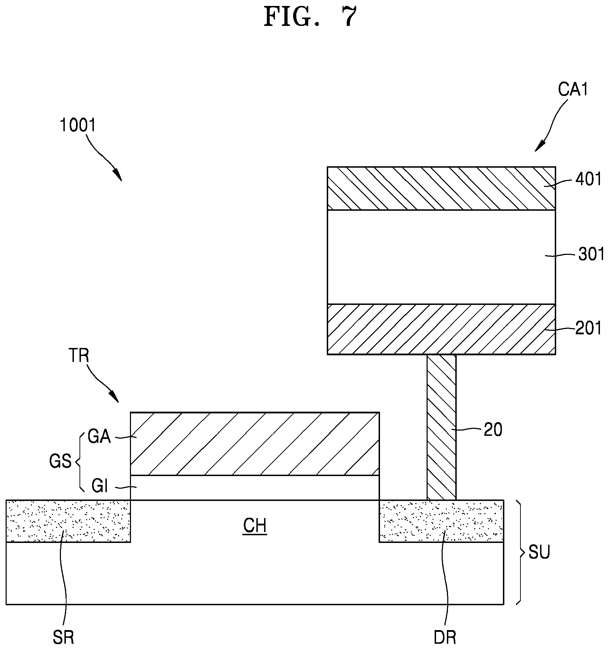

FIG. 7 is a schematic diagram illustrating an electronic device according to at least one embodiment.

Referring to FIG. 7, an electronic device 1001 may include a structure in which a capacitor CA1 and a transistor TR are electrically connected via a contact 20. The capacitor CA1 includes a lower electrode 201, an upper electrode 401, and a dielectric thin film 301 provided between the lower electrode 201 and the upper electrode 401. The capacitor CA1 may be the capacitor 100 as described with reference to FIG. 1. For example, the description of the lower electrode 201 may refer to the description of the first electrode layer 110 in the aforementioned capacitor 100, the description of the dielectric thin film 301 may refer to the description of the dielectric layer 150 and the interlayer 130 in the aforementioned capacitor 100, and the description of the upper electrode 401 may refer to the description of the aforementioned second electrode layer 190.

The transistor TR may be a field effect transistor. The transistor TR includes a semiconductor substrate SU including a source region SR, a drain region DR, and a channel region CH, and a gate stack GS disposed on the semiconductor substrate SU to face the channel region CH and including a gate insulating layer GI and a gate electrode GA.

The channel region CH is a region between the source region SR and the drain region DR, and is electrically connected to the source region SR and the drain region DR. The source region SR may be electrically connected to or in contact with one end of the channel region CH, and the drain region DR may be electrically connected to or in contact with the other end of the channel region CH. The channel region CH may be defined in the semiconductor substrate SU as a substrate region between the source region SR and the drain region DR.

The semiconductor substrate SU may include a semiconductor material. The semiconductor substrate SU may include, for example, an elemental and/or compound semiconductor material such as silicon (Si), germanium (Ge), silicon-germanium (SiGe), silicon carbide (SiC), gallium arsenide (GaAs), indium arsenide (InAs), indium phosphide (InP). In addition, the semiconductor substrate SU may include a silicon-on-insulator (SOI) substrate.

The source region SR, the drain region DR, and the channel region CH may be each independently formed by, e.g., injecting impurities into different regions of the semiconductor substrate SU, and, in this case, the source region SR, the channel region CH, and the drain region DR may include a substrate material as a base material. The source region SR and the drain region DR may be formed of a conductive material. In this case, the source region SR and the drain region DR may include, for example, a metal, a metal compound, or a conductive polymer.

The channel region CH may be implemented as a separate material layer (thin film), unlike what is illustrated in the drawing. In these cases, the channel CH may include, for example, at least one among Si, Ge, SiGe, a group III-V semiconductor, an oxide semiconductor, a nitride semiconductor, an oxynitride semiconductor, a two-dimensional (2D) material, a quantum dot (QD), an organic semiconductor, and/or the like. For example, the oxide semiconductor may include InGaZnO and/or the like, the two-dimensional material may include transition metal dichalcogenide (TMD), graphene, and/or the like, and the quantum dot may include a colloidal QD, a nanocrystal structure, and/or the like. In at least some embodiments, the separate material layer may be transferred to or formed on a substrate and the source region SR and/or drain region DR regions deposited on and/or under the separate material layer.

The gate electrode GA may be disposed on the semiconductor substrate SU to be spaced apart from the semiconductor substrate SU and to face the channel region CH. The gate electrode GA may include at least one among a metal, a metal nitride, a metal carbide, a polysilicon, and/or the like. For example, the metal may include at least one among aluminum (Al), tungsten (W), molybdenum (Mo), titanium (Ti), and tantalum (Ta), and the metal nitride film may include at least one of a titanium nitride film (TiN film) or a tantalum nitride film (TaN film). The metal carbide may include at least one of metal carbides doped with (or containing) aluminum and/or silicon, and specific examples thereof may include TiAlC, TaAlC, TiSiC, or TaSiC.

The gate electrode GA may have a structure in which a plurality of materials are stacked, and may have, for example, a stacked structure of a metal nitride layer/metal layer such as TiN/Al or a stacked structure of a metal nitride layer/metal carbide layer/metal layer such as TiN/TiAlC/W. However, the examples are not limited thereto.

A gate insulating layer GI may be further disposed between the semiconductor substrate SU and the gate electrode GA. The gate insulating layer GI may include a paraelectric material and/or a high-k dielectric material, and have a dielectric constant of about 20 to about 70.

For example, the gate insulating layer GI may include at least one of a silicon oxide, a silicon nitride, an aluminum oxide, a hafnium oxide, a zirconium oxide, and/or the like; and/or include a two-dimensional (2D) insulator such as hexagonal boron nitride (h-BN). For example, the gate insulating layer GI may include at least one of silicon oxide ($SiO_2$, x is a real number), a silicon nitride ($SiN_x$), hafnium oxide ($HfO_2$), hafnium silicon oxide ($HfSiO_4$), lanthanum oxide ($La_2O_3$), lanthanum aluminum oxide ($LaAlO_3$), zirconium oxide ($ZrO_2$), hafnium zirconium oxide ($HfZrO_2$ or $HfZrO_4$), zirconium silicon oxide ($ZrSiO_4$), tantalum oxide ($Ta_2O_5$)), titanium oxide ($TiO_2$), strontium titanium oxide ($SrTiO_3$), yttrium oxide ($Y_2O_3$), aluminum oxide ($Al_2O_3$), lead scandium tantalum oxide ($PbSc_{0.5}Ta_{0.5}O_3$), lead zinc niobate (PbZn-NbOs), and/or the like. Additionally, the gate insulating layer GI may include at least one of a metal oxynitride such as aluminum oxynitride (AlON), zirconium oxynitride (ZrON), hafnium oxynitride (HfON), lanthanum oxynitride (LaON), yttrium oxynitride (YON); a silicate such as ZrSiON, HfSiON, YSiON, LaSiON; or an aluminate such as ZrAlON, HfAlON, and/or the like. The gate insulating layer GI and the gate electrode GA may form a gate stack.

One of electrodes 201 and 401 in the capacitor CA1, and one of the source region SR and the drain region DR in the transistor TR may be electrically connected via a contact 20. Herein, the contact 20 may include a conductive material, for example, tungsten, copper, aluminum, polysilicon, etc. In at least one embodiment, the contact 20 may be omitted, and the one of the electrodes 201 and 401 and the one of the source region SR and the drain region DR may be in direct contact.

Arrangement of the capacitor CA1 and the transistor TR may be variously modified. For example, the capacitor CA1 may be disposed on the semiconductor substrate SU, or also be buried in the semiconductor substrate SU.

FIG. 7 illustrates an electronic device 1001 including one capacitor CA1 and one transistor TR. However, this is an example, and the electronic device 1001 may include a plurality of capacitors and a plurality of transistors.

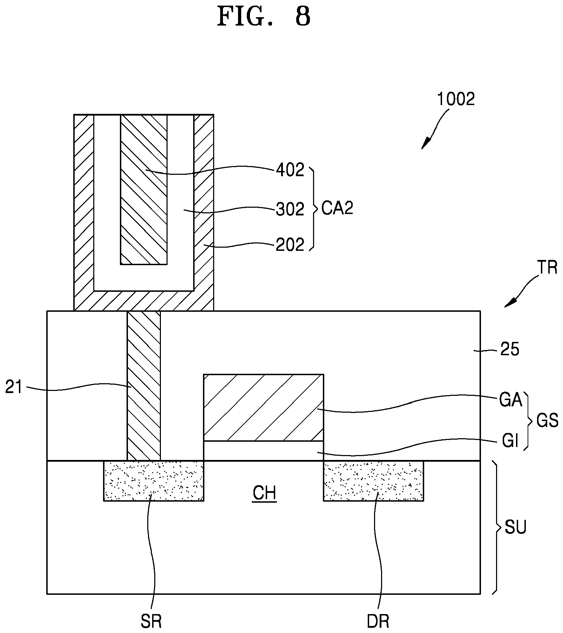

FIG. 8 illustrates an electronic device according to another embodiment.

Referring to FIG. 8, an electronic device 1002 may include a structure in which a capacitor CA2 and a transistor TR are electrically connected via a contact 21.

The transistor TR includes a semiconductor substrate SU including a source region SR, a drain region DR, and a channel region CH, and a gate stack GS disposed on the semiconductor substrate SU to face the channel region CH and including a gate insulating layer GI and a gate electrode GA.

The interlayer insulating film 25 may be provided on the semiconductor substrate SU in a form covering the gate stack GS. The interlayer insulating film 25 may include an insulating material. For example, the interlayer insulating film 25 may include a Si oxide (for example, $SiO_2$), an Al oxide (for example, $Al_2O_3$), a high-k dielectric material (for example, $HfO_2$), and/or the like. The contact 21 penetrates the interlayer insulating film 25 to electrically connect the transistor TR and the capacitor CA2.

The capacitor CA2 includes the lower electrode 202, the upper electrode 402, and a dielectric thin film 302 provided between the lower electrode 202 and the upper electrode 402. The lower electrode 202 and the upper electrode 402 are presented in a shape that enables a contact area to be maximized, and a material of the capacitor CA2 is substantially the same as the capacitor 100 in FIG. 1. For example, the description of the lower electrode 202 may refer to the description of the first electrode layer 110 in the aforementioned capacitor 100, the description of the dielectric thin film 302 may refer to the description of the dielectric layer 150 and the interlayer 130 in the aforementioned capacitor 100, and the description of the upper electrode 402 may refer to the description of the aforementioned second electrode layer 190.

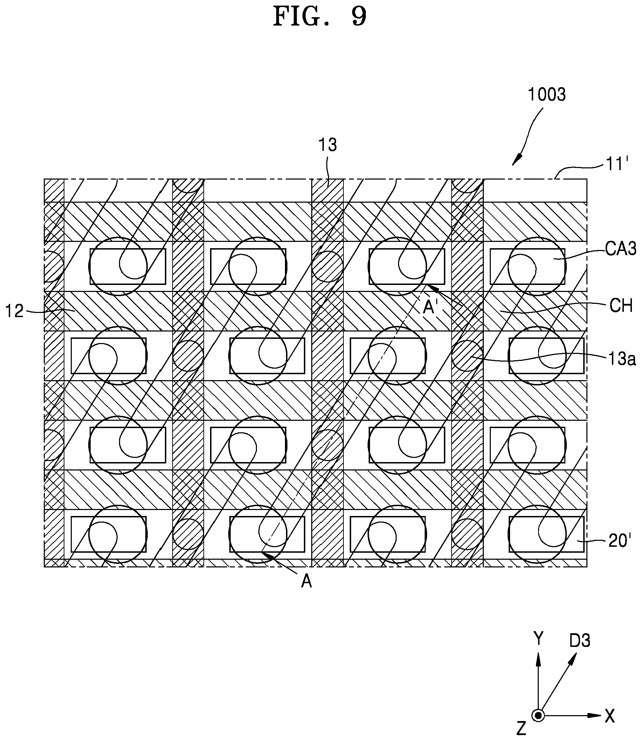

FIG. 9 is a plan view illustrating an electronic device according to another embodiment.

Referring to FIG. 9, an electronic device 1003 may include a structure in which a plurality of capacitors and a plurality of field effect transistors are repeatedly arranged. The electronic device 1003 may include: a field effect transistor including a semiconductor substrate 11' having a source, a drain, and a channel, and a gate stack 12; a contact structure 20' disposed on the semiconductor substrate 11' not to overlap the gate stack 12; and a capacitor CA3 disposed on the contact structure 20', and may further include a bit line structure 13 electrically connecting the plurality of field effect transistors.

FIG. 9 illustrates a configuration in which both of the contact structure 20' and the capacitor CA3 are repeatedly arranged along the X direction and the Y direction, but the configuration is not limited thereto. For example, the contact structure 20' may be arranged along the X direction and the Y direction, and the capacitor CA3 may be arranged in a hexagonal shape, such as a honeycomb structure.

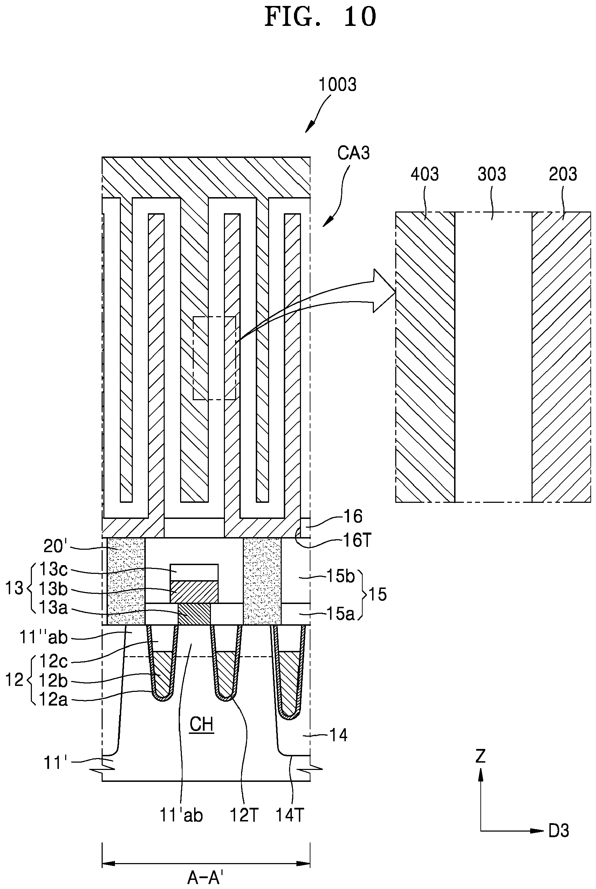

FIG. 10 is a cross-sectional view taken along line A-A' in FIG. 9.

Referring to FIG. 10, a semiconductor substrate 11' may have a shallow trench isolation (STI) structure including an element isolation film 14. The element isolation film 14 may be a single layer formed of a single insulating film, or a multilayer formed of a combination of two or more insulating films. The element isolation film 14 may include an element isolation trench 14T in the semiconductor substrate 11', and the element isolation trench 14T may be filled with an insulating material. The insulating material may include at least one of fluoride silicate glass (FSG), undoped silicate glass (USG), boro-phospho-silicate glass (BPSG), phospho-silicate glass (PSG), flowable oxide (FOX), plasma enhanced tetra-ethyl-ortho-silicate(PE-TEOS), or tonen silazene (TOSZ), but is not limited thereto.

The semiconductor substrate 11' may further include a channel region CH defined by the element isolation film 14, and a gate line trench 12T parallel to an upper surface of the semiconductor substrate 11' and disposed to extend along X direction. The channel region CH may have a relatively long island shape having a minor axis and a major axis. The major axis of the channel region CH may be arranged along a D3 direction parallel to the upper surface of the semiconductor substrate 11' as illustrated in FIG. 10.

The gate line trench 12T may be disposed to cross the channel region CH at a predetermined (and/or otherwise determined) depth from the upper surface of the semiconductor substrate 11', and/or disposed in the channel region CH. The gate line trench 12T may also be disposed inside the element isolation trench 14T, and the gate line trench 12T in the element isolation trench 14T may have a bottom surface lower than the gate line trench 12T in the channel region CH. A first source/drain 11'ab and a second source/drain 11"ab may be disposed on an upper portion of the channel region CH located on both sides of the gate line trench 12T.

A gate stack 12 may be disposed in the gate line trench 12T. For example, a gate insulating layer 12a, a gate electrode 12b, and a gate capping layer 12c may be sequentially disposed inside the gate line trench 12T. Description of the gate insulating layer 12a and the gate electrode 12b may refer to the foregoing description, and the gate capping layer 12c may include at least one among a silicon oxide, a silicon oxynitride, a silicon nitride, and/or the like. The gate capping layer 12c may be disposed on the gate electrode 12b so as to fill a remaining portion of the gate line trench 12T.

A bit line structure 13 may be disposed on the first source/drain 11'ab. The bit line structure 13 may be disposed to be parallel to an upper surface of the semiconductor substrate 11' and to extend along Y direction. The bit line structure 13 may be electrically connected to the first source/drain 11'ab and may sequentially include a bit line contact 13a, a bit line 13b, and a bit line capping layer 13c on the substrate. For example, the bit line contact 13a may include polysilicon, the bit line 13b may include a metal material, and the bit line capping layer 13c may include an insulating material such as a silicon nitride or a silicon oxynitride.

FIG. 10 illustrates that the bit line contact 13a has a bottom surface coplanar with the upper surface of the semiconductor substrate 11'. However, this is an example, and the bit line contact is not limited thereto. For example, according to another example, a recess formed to a predetermined (or otherwise determined) depth from the upper surface of the semiconductor substrate 11' may be further provided, the bit line contact 13a extends to the inside of the recess, and thus the bottom surface of the bit line contact 13a may be lower than the upper surface of the semiconductor substrate 11'.

The bit line structure 13 may further include a bit line interlayer (not illustrated) between the bit line contact 13a and the bit line 13b. The bit line interlayer may include a metal silicide such as a tungsten silicide, and a metal nitride such as a tungsten nitride. Additionally, a bit line spacer (not illustrated) may be further formed on a sidewall of the bit line structure 13. The bit line spacer may have a single layer structure or a multilayer structure, and may include an insulating material such as a silicon oxide, a silicon oxynitride, or a silicon nitride. Additionally, the bit line spacer may further include an air space (not illustrated).

A contact structure 20' may be disposed on the second source/drain 11"ab. The contact structure 20' and the bit line structure 13 may be differently disposed on the source/drain on the substrate, respectively. The contact structure 20' may be a structure in which a lower contact pattern (not illustrated), a metal silicide layer (not illustrated), and an upper contact pattern (not illustrated) are sequentially stacked on the second source/drain 11"ab. The contact structure 20' may also further include a barrier layer (not illustrated) surrounding side surfaces and a bottom surface of the upper contact pattern. For example, the lower contact pattern may include polysilicon, the upper contact pattern may include a metal material, and the barrier layer may include a metal nitride having conductivity.

The capacitor CA3 may be electrically connected to the contact structure 20' and disposed on the semiconductor substrate 11'. Specifically, the capacitor CA3 includes a lower electrode 203 electrically connected to the contact structure 20', an upper electrode 403 disposed to be spaced apart from the lower electrode 203, and a dielectric thin film 303 disposed between the lower electrode 203 and the upper electrode 403. The lower electrode 203 may have a cylinder shape or a cup shape, which has an inner space of which the bottom is closed. The upper electrode 403 may have a comb-like shape having an inner space formed by the lower electrode 203 and comb teeth extending to a region between adjacent lower electrodes 203. The dielectric thin film 303 may be disposed between the lower electrode 203 and the upper electrode 403 to be parallel to surfaces thereof.

Materials of the lower electrode 203, the dielectric thin film 303, and the upper electrode 403, which form the capacitor CA3 are the same as the materials of the capacitor 100 described in FIG. 1. For example, the description of the lower electrode 203 may refer to the description of the first electrode layer 110 in the aforementioned capacitor 100, the description of the dielectric thin film 303 may refer to the description of the dielectric layer 150 and the interlayer 130 in the aforementioned capacitor 100, and the description of the upper electrode 403 may refer to the description of the aforementioned second electrode layer 190.

An interlayer insulating film 15 may be further disposed between the capacitor CA3 and the semiconductor substrate 11'. The interlayer insulating film 15 may be disposed in a space between the capacitor CA3 and the semiconductor substrate 11', where no other structure is disposed. Specifically, the interlayer insulating film 15 may be disposed to cover wiring and/or an electrode structure such as the bit line structure 13, the contact structure 20', and a gate stack 12 on the substrate. For example, the interlayer insulating film 15 may surround walls of the contact structure 20'. The interlayer insulating film 15 may include a first interlayer insulating film 15a surrounding the bit line contact 13a, and a second interlayer insulating film 15b covering side surfaces and/or upper surfaces of the bit line 13b and the bit line capping layer 13c.

The lower electrode 203 of the capacitor CA3 may be disposed on the interlayer insulating film 15, specifically on the second interlayer insulating film 15b. In addition, when a plurality of capacitors CA3 are disposed, the bottom surfaces of a plurality of the lower electrodes 203 may be separated by an etch stop layer 16. In other words, the etch stop layer 16 may include an opening 16T, and the bottom surface of the lower electrode 203 of the capacitor CA3 may be disposed in the opening 16T. The lower electrode 203, as described, may have a cylinder shape or a cup shape, which has an inner space of which the bottom is closed. The capacitor CA3 may further include a support part (not illustrated) preventing the lower electrode 203 from being leaned or fallen, and the support part may be disposed on the sidewall of the lower electrode 203.

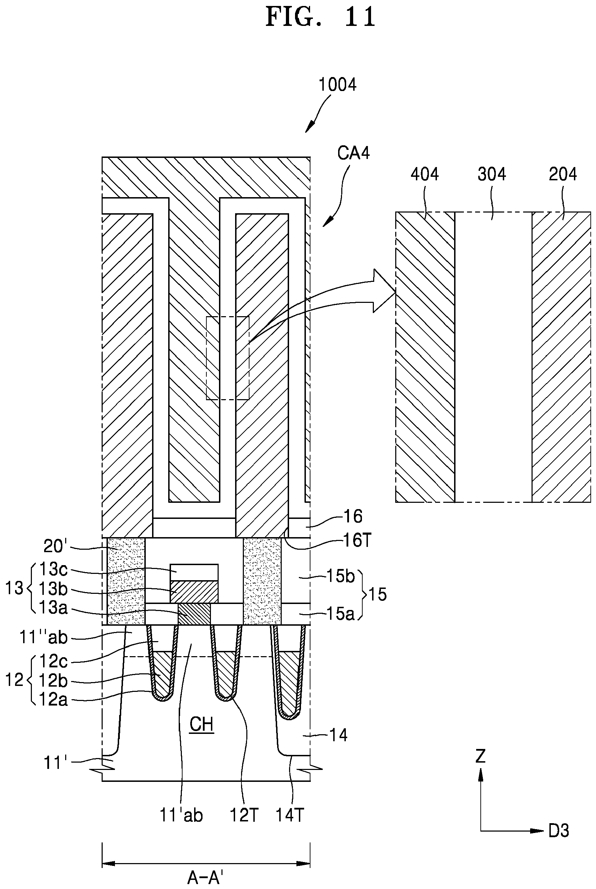

FIG. 11 is a cross-sectional view illustrating an electronic device according to another embodiment.

An electronic device 1004 according to at least one embodiment is illustrated as a cross-sectional view corresponding to a cross-sectional view taken along A-A' in FIG. 9, and differs from that in FIG. 9 only in terms of a shape of a capacitor CA4. The capacitor CA4 is disposed on a semiconductor substrate 11' to be electrically connected to a contact structure 20', and includes a lower electrode 204 electrically connected to the contact structure 20', an upper electrode 404 disposed to be spaced apart from the lower electrode 204, and a dielectric thin film 304 disposed between the lower electrode 204 and the upper electrode 404. Materials of the lower electrode 204, the dielectric thin film 304, and the upper electrode 404 are the same as the materials of the capacitor 100 described with reference to FIG. 1. For example, the description of the lower electrode 204 may refer to the description of the first electrode layer 110 in the aforementioned capacitor 100, the description of the dielectric thin film 304 may refer to the description of the dielectric layer 150 and the interlayer 130 in the aforementioned capacitor 100, and the description of the upper electrode 404 may refer to the description of the aforementioned second electrode 190.

The lower electrode 204 may have a pillar shape, such as a cylinder, a quadrangular pillar, or a polygonal pillar, extending along the vertical direction (Z direction). The upper electrode 404 may have a comb-like shape having comb teeth extending to a region between adjacent lower electrodes 204. The dielectric thin film 304 may be disposed between the lower electrode 204 and the upper electrode 404 to be parallel to surfaces thereof.

The aforementioned capacitors and electronic devices may be applied to various application fields. For example, an electronic device according to embodiments may be applied as a logic element or a memory element. Electronic devices, according to embodiments may be used for arithmetic operations, program execution, and temporary data storage on apparatuses, such as mobile apparatuses, computers, laptops, sensors, network apparatuses, neuromorphic devices, etc. In addition, the electronic elements and electronic devices according to embodiments may be useful in electronic apparatuses which have large data transmission volume and continuously transmit data.

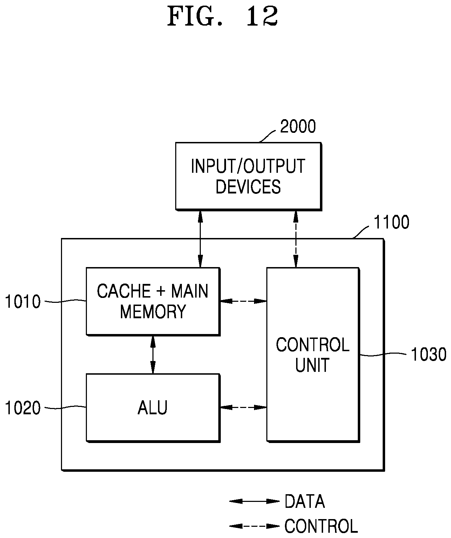

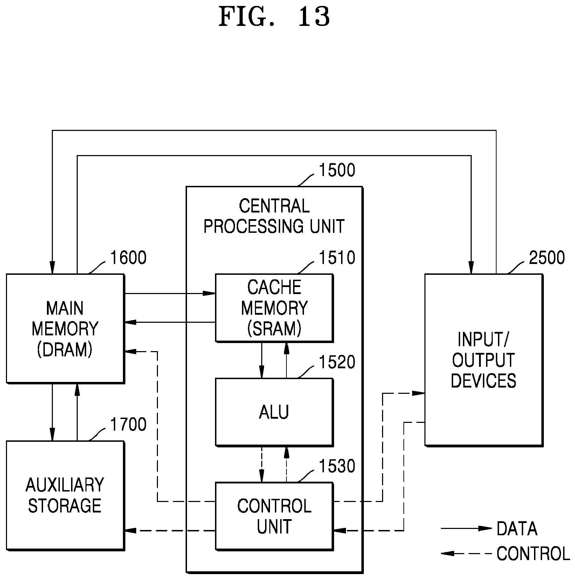

FIGS. 12 and 13 are each a conceptual view schematically illustrating an element architecture applicable to a device according to at least one embodiment.

Referring to FIG. 12, an electronic element architecture 1100 may include a memory unit 1010, an arithmetic logic unit (ALU) 1020, and a control unit 1030. The memory unit 1010, the ALU 1020, and the control unit 1030 may be electrically connected. For example, the electronic element architecture 1100 may be implemented in a single chip including the memory unit 1010, the ALU 1020 and the control unit 1030.

The memory unit 1010, the ALU 1020, and the control unit 1030 may be connected to each other through a metal line on a chip to communicate directly with each other. The memory unit 1010, the ALU 1020 and the control unit 1030 are monolithically integrated on one substrate to form a single chip. An input/output element 2000 may be connected to the electronic element architecture (chip) 1100. In addition, the memory unit 1010 may include both of a main memory and a cache memory. The electronic element architecture (chip) 1000 may be an on-chip memory processing unit. The memory unit 1010 may include the aforementioned capacitor and/or an electronic device utilizing the same. Also, the ALU 1020 or the control unit 1030 may each include the aforementioned capacitor.

Referring to FIG. 13, a cache memory 1510, an ALU 1520, and a control unit 1530 may configure a central processing unit (CPU) 1500, and the cache memory 1510 may include (or be included in) a static random access memory (SRAM). In addition to the CPU 1500, a main memory 1600 and an auxiliary storage 1700 may be provided. The main memory 1600 may be a dynamic random access memory (DRAM), and may include the aforementioned capacitor. In some cases, the electronic element architecture may be implemented in a form in which computing unit elements and memory unit elements are adjacent to each other on a single chip without distinguishing sub-units.

The present disclosure will be described in more detail through Examples and Comparative Examples hereafter. However, Examples are provided to illustrate the present invention, and the scope of the present invention is not limited thereto.

[Examples]

**Example 1: Manufacturing of Capacitor**

TiN was prepared as a first electrode layer. A $Ga_2O_3$ thin film was grown on the first electrode using atomic layer deposition (ALD) to form an interlayer. A dielectric layer of $HfO_2$ was formed on the interlayer, and was annealed under a temperature condition of about 500 °C. A second electrode layer of Pt was formed on the dielectric layer to manufacture a capacitor according to Example 1.

**Example 2**

A capacitor according to Example 2 was manufactured in the same manner as in Example 1, except for using $In_2O_3$ in place of $Ga_2O_3$.

**Comparative Example 1**

A capacitor according to Comparative Example 1 was manufactured in the same manner as in Example 1, except that the interlayer is not formed.

**Evaluation Example 1: Evaluation of capacitance characteristics**

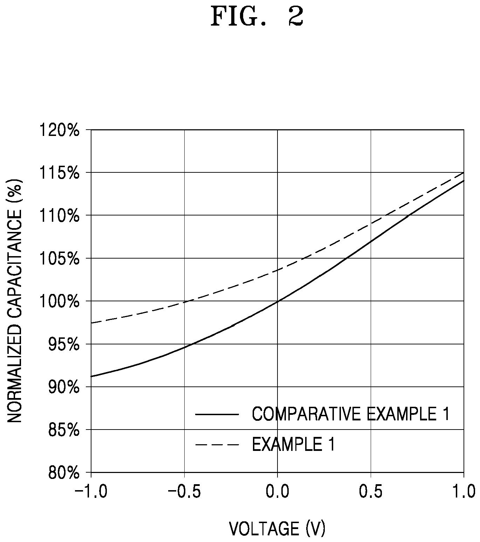

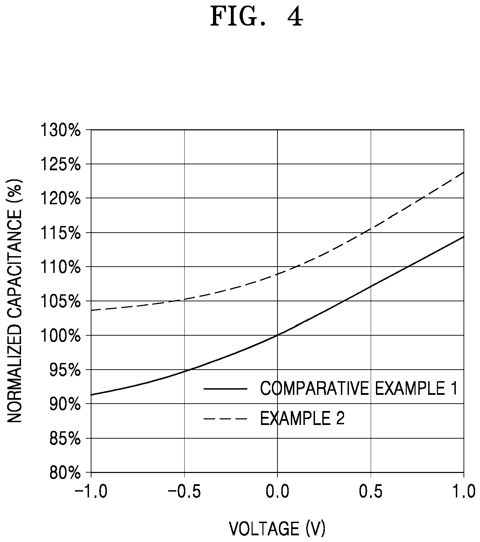

Capacitances of the capacitors manufactured according to Examples 1 and 2, and Comparative Example 1 were measured, and the measurement results were shown in FIGS. 2 and 4. A Keithley 4200A Analyzer was used as a measuring instrument, and capacitance was measured with respect to a voltage change (from -1 V to 1 V). A thickness of the dielectric layer is represented by an equivalent oxide thickness ($T_{oxeq}$)).

Referring to FIGS. 2 and 4, capacitors according to Examples 1 and 2 exhibit significantly excellent capacitance characteristics compared to a capacitor according to Comparative Example 1.

**Evaluation Example 2: Evaluation of leakage current characteristics**

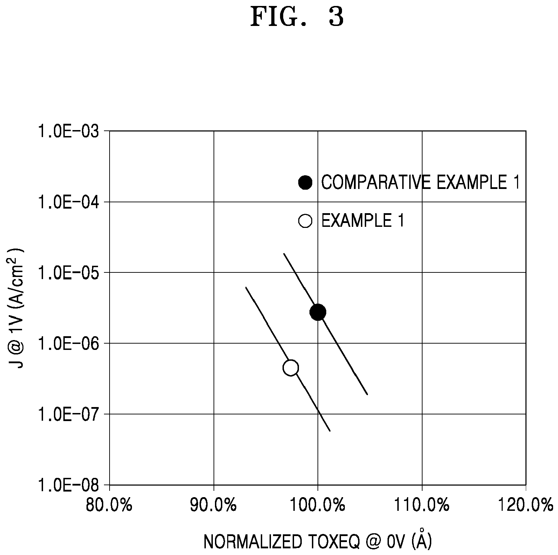

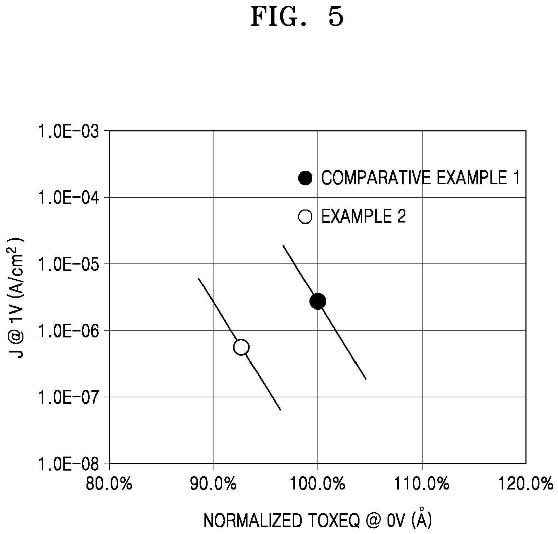

Leakage current versus an equivalent oxide thickness ($T_{oxeq}$) was measured for the capacitors manufactured according to Examples 1 and 2, and Comparative Example 1, and the measurement results were shown in FIGS. 3 and 5. A Keithley 4200A Analyzer was used as a measuring instrument, and leakage current is a current density when a voltage of 1 V is applied to the capacitor. A thickness of the dielectric layer is represented as an equivalent oxide thickness.

Referring to FIGS. 3 and 5, it can be seen that compared to the capacitor according to Comparative Example 1, the capacitors according to Examples 1 and 2 have a relatively lower equivalent oxide thickness, ( e.g., exhibit a higher dielectric constant and lower leakage current characteristics).

Hitherto, at least one embodiment has been described, the disclosure should not be limited to these embodiments, but various modifications from these embodiments are possible by those skilled in the art.

The capacitor described above, and an electronic device including the same have been described with reference to Examples illustrated in figures, and it is understood that the present disclosure should not be limited to these embodiments, but various changes, modifications, and other equivalent embodiments can be made by one ordinary skilled in the art. Therefore, embodiments disclosed should be considered from an illustrative rather than limiting perspective. The scope of the present specification is defined not by the detailed description of the disclosure but by the appended claims, and all differences within the scope will be construed as being included in the disclosure.

A capacitor according to at least one embodiment, may have a dielectric layer having excellent structural stability and dielectric characteristics, and have high capacitance and low leakage current characteristics. Therefore, a high-quality electronic device may be implemented using the capacitor.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A capacitor comprising:

   a first electrode layer;
   a second electrode layer;
   a dielectric layer between the first electrode layer and the second electrode layer; and
   an interlayer between the first electrode layer and the dielectric layer,
   wherein the interlayer includes a first interface material and the first interface material includes at least one Group 13 element other than aluminum.

2. The capacitor of claim 1, wherein the at least one Group 13 element included in the first interface material is at least one of boron (B), gallium (Ga), indium (In), or thallium (Tl).

3. The capacitor of claim 1 or 2, wherein the first interface material includes an oxide of the at least one Group 13 element.

4. The capacitor of any preceding claim, wherein

   the at least one Group 13 element included in the first interface material is at least one of gallium (Ga) or indium (In), and
   the first interface material includes at least one of gallium oxide, indium oxide, or a combination thereof.

5. The capacitor of any preceding claim, wherein the interlayer consists of a first layer including the first interface material.

6. The capacitor of any preceding claim, wherein

   the interlayer includes at least a first layer and a second layer,
   the first layer includes the first interface material,
   the second layer includes a second interface material, and
   the second interface material includes at least one Group 13 element, and optionally wherein the first interface material and the second interface material are different from each other.

7. The capacitor of any preceding claim, wherein

   the interlayer is in direct contact with the first electrode layer, and
   the interlayer is in direct contact with the dielectric layer.

8. The capacitor of any preceding claim, wherein the interlayer includes an amorphous structure.

9. The capacitor of any preceding claim, wherein the interlayer has a thickness of 15 Å or less.

10. The capacitor of any preceding claim, wherein

    the first electrode layer includes a first electrode material, and
    the first electrode material includes at least one of a metal, an oxide, or a nitride, and includes at least one of titanium (Ti), nickel (Ni), aluminum (Al), tantalum (Ta), tungsten (W), platinum (Pt), palladium (Pd), gold (Au), iridium (Ir), rhodium (Rh), molybdenum (Mo), vanadium (V), or niobium (Nb) as a base element, and optionally wherein the interlayer further includes the base element of the first electrode material.

**11.** The capacitor of claim 10, wherein the interlayer includes a compound represented by the following formula

$$A_xM_yO_z$$

wherein

A represents the Group 13 element other than aluminum,
M represents the base element included in the first electrode material,
O represents oxygen, and

$$0 < x \leq 5; \ 0 \leq y \leq 5; \ \text{and} \ 0 < z \leq 5.$$

**12.** The capacitor of claim 10 or 11, wherein

the interlayer includes at least a first mixed region in direct contact with the first electrode layer, and
the first mixed region includes a mixture of the first interface material and at least one of the base element or an oxide of the base element.

**13.** The capacitor of any preceding claim, wherein

the dielectric layer includes a dielectric material, and
the dielectric material includes at least one of Zr, Hf, Ti, or Al as a base element, and optionally wherein:

the interlayer includes at least a second mixed region in direct contact with the dielectric layer; and
the second mixed region includes a mixture of the first interface material and at least one of the base element or an oxide of the base element.

**14.** An electronic device comprising:

a transistor; and
the capacitor, according to any preceding claim, electrically connected to the transistor.

**15.** The electronic device of claim 14, wherein the transistor includes

a semiconductor substrate including a source region, a drain region, and a channel region between the source region and the drain region, and
a gate stack either:

facing the channel region and including a gate insulating layer and a gate electrode; or
in a trench defined by the semiconductor substrate such that the gate stack faces the channel region, the gate stack including a gate insulating layer and a gate electrode,
wherein the electronic device optionally further comprises a memory unit including the capacitor and the transistor, and
a control unit electrically connected to the memory unit, and configured to control the memory unit.

# FIG. 1

100

| |
|---|
| 190 |
| 150 |
| 130 |
| 110 |

# FIG. 2

# FIG. 3

# FIG. 4

FIG. 5

## FIG. 6

# FIG. 7

# FIG. 8

# FIG. 9

# FIG. 10

# FIG. 11

# FIG. 12

# FIG. 13

DATA ———▶

CONTROL ◀— — —